(19) Europäisches Patentamt
European Patent Office
Office européen des brevets

(11) **EP 3 820 729 B1**

(12) **EUROPÄISCHE PATENTSCHRIFT**

(45) Veröffentlichungstag und Bekanntmachung des Hinweises auf die Patenterteilung:
**30.08.2023 Patentblatt 2023/35**

(21) Anmeldenummer: **19729283.2**

(22) Anmeldetag: **07.06.2019**

(51) Internationale Patentklassifikation (IPC):
**B60L 3/00** *(2019.01)*    **G01R 31/396** *(2019.01)*
**G01R 31/3835** *(2019.01)*    **B60L 58/21** *(2019.01)*

(52) Gemeinsame Patentklassifikation (CPC):
**G01R 31/3835; B60L 3/0038; B60L 3/0046; B60L 58/21; G01R 31/396; H02J 7/0014; H02J 7/0048; H02J 7/005;** B60L 2240/547; G01R 31/367; Y02T 10/70

(86) Internationale Anmeldenummer:
**PCT/EP2019/064999**

(87) Internationale Veröffentlichungsnummer:
**WO 2020/011459 (16.01.2020 Gazette 2020/03)**

(54) **VERFAHREN ZUM BETRIEB EINES BATTERIEMODULS**

METHOD FOR OPERATING A BATTERY MODULE

PROCÉDÉ POUR FAIRE FONCTIONNER UN MODULE DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2018 DE 102018211724**

(43) Veröffentlichungstag der Anmeldung:
**19.05.2021 Patentblatt 2021/20**

(73) Patentinhaber: **Robert Bosch GmbH**
**70442 Stuttgart (DE)**

(72) Erfinder:
• **WOLL, Christoph**
**70839 Gerlingen (DE)**
• **SHEN, Tunan**
**71229 Leonberg (DE)**
• **SCHMIDT, Alexander**
**78166 Donaueschingen (DE)**

(56) Entgegenhaltungen:
WO-A1-2015/037292    DE-A1-102013 205 334
DE-A1-102014 207 395    DE-A1-102017 116 573
US-A1- 2005 225 290    US-A1- 2006 273 802

**Beschreibung**

Die Erfindung betrifft ein Verfahren zum Betrieb eines Batteriemoduls mit mehreren Batteriezellen, insbesondere in einem elektrisch angetriebenen Fahrzeug, wobei die Zellspannungen der einzelnen Batteriezellen ermittelt werden. Das erfindungsgemäße Verfahren gestattet insbesondere einen weiteren Betrieb des Batteriemoduls in einem Fehlerfall, wenn eine Zellspannung einer Batteriezelle zu einem Betriebszeitpunkt nicht messbar ist.

Stand der Technik

Heutige Batteriemodule in Batteriesystemen von elektrisch angetriebenen Fahrzeugen weisen mehrere Batteriezellen auf. Die Batteriemodule sind derart ausgelegt, dass die einzelnen Batteriezellen in Serie miteinander verschaltet sind, um eine ausreichend hohe Spannung bereitstellen zu können. Im Betrieb des Fahrzeugs werden die Batteriezellen zum Antrieb des Fahrzeugs und zur Versorgung weitere Verbraucher entladen. Aber auch bei einem ruhenden Fahrzeug findet eine geringe Entladung der Batteriezellen in Form einer Selbstentladung statt.

Die Entladung der Batteriezellen findet dabei nicht zwingend gleichmäßig statt. Die Spannungen der Batteriezellen liegen somit nicht alle auf dem gleichen Niveau. Grund hierfür sind unterschiedliche Selbstentladung als auch unterschiedliche Alterung einzelner Zellen. Mit zunehmender Alterung werden die Batteriezellen schneller entladen. Die Batteriezelle mit der höchsten Spannung bestimmt das Ende eines Ladevorgangs, und die Batteriezelle mit der niedrigsten Spannung bestimmt das Ende eines Entladevorgangs.

Heutige elektrisch angetriebene Fahrzeuge weisen ein Batteriemanagementsystem auf, welches Überwachungsfunktionen und Diagnosefunktionen vom Komponentenschutz bis hin zur Insassensicherheit enthält. Insbesondere werden die Zellspannungen der einzelnen Batteriezellen gemessen und überwacht. Falls in dem Batteriesystem Fehler auftreten, so müssen diese schnellst möglichst erkannt und eine Maßnahme ergriffen werden. Ein Fahrzeug wird im Fehlerfall nicht zwingend sofort abgeschaltet, da dies für den nachfolgenden Verkehr ein Sicherheitsrisiko darstellt. Je nach Fehlerschwere wird das Fahrzeug in einen Notlaufbetrieb versetzt und kann noch eine bestimmte Zeit mit reduzierter Leistung weiter fahren bis ein sicherer Abstellplatz gefunden ist, oder das Batterieschütz öffnet bei kritischen Fehlern, beispielsweise bei einem Kurzschluss einer Batteriezelle, und das Fahrzeug rollt nur noch aus.

In einem autonomen elektrisch angetriebenen Fahrzeug, insbesondere in einem autonomen Shuttle oder Roboter Taxi, ist kein Fahrer anwesend, der in einem Fehlerfall eingreifen kann, um das Fahrzeug sicher aus einem Gefahrenbereich zu manövrieren. Das Fahrzeug muss selbst entscheiden können, wie es mit dem aktuellen Fehler umgeht, beispielsweise ob eine Weiterfahrt bis zu der nächsten Servicestation oder Endhaltestelle möglich ist, oder ob sofort angehalten werden muss. Gegebenenfalls ist zu entscheiden, ob das Fahrzeug mit gleicher Leistung weiter betrieben werden kann oder ob die Weiterfahrt mit reduzierter Leistung und reduzierter Geschwindigkeit erfolgt.

Aufgrund eines Ausfalls einer Messleitung kann die Zellspannung der betroffenen Batteriezelle nicht mehr gemessen werden. Dies führt in heutigen Fahrzeugen aus Sicherheitsgründen zu einem Abschalten des gesamten Batteriesystems oder zu einem Abschalten des betroffenen Batteriemoduls und somit zu einem reduzierten Fahrbetrieb. Das bedeutet, dass das Fahrzeug nur noch mit reduzierter Leistung und damit reduzierter Geschwindigkeit weiterfahren kann. Dieser Notlaufbetrieb ermöglicht es, sicher von der Straße weg zu kommen und auf einem Parkplatz oder in einer Nothaltebucht das Fahrzeug abstellen zu können oder auch noch die nächste Werkstatt zu erreichen. Für das autonome Fahren gibt es verschiedene Sicherheitsstufen, die sich unter anderem in unterschiedlich langen Fahrwegen nach dem Auftreten eines Fehlers unterscheiden.

Relevante Offenbarungen aus dem Stand der Technik werden in DE 10 2017 116573 A1, DE 10 2014 207395 A1, US 2005/225290 A1, DE 10 2013 205334 A1, US 2006/273802 A1 und WO 2015/037292 A1 offenbart.

Offenbarung der Erfindung

Es wird ein Verfahren zum Betrieb eines Batteriemoduls mit mehreren Batteriezellen vorgeschlagen. Die Batteriezellen sind dabei insbesondere elektrisch seriell verschaltet. Das Batteriemodul ist beispielsweise in einem elektrisch angetriebenen Fahrzeug eingesetzt, wobei die Zellspannungen der einzelnen Batteriezellen gemessen werden. Das erfindungsgemäße Verfahren dient dabei insbesondere zum Sicherstellen eines weiteren Betriebs des Batteriemoduls in einem Fehlerfall, wenn eine Zellspannung einer Batteriezelle des Batteriemoduls zu einem Betriebszeitpunkt nicht messbar ist. Das erfindungsgemäße Verfahren umfasst dabei mindestens die nachfolgend genannten Schritte:
In einem Schritt a) erfolgt eine Ermittlung der Zellspannungen der einzelnen Batteriezellen zu einem Startzeitpunkt. Die ermittelte Zellspannung einer Batteriezelle zu dem Startzeitpunkt ist beispielsweis eine zu dem Startzeitpunkt selbst oder zu einem vor dem Startzeitpunkt liegenden Messzeitpunkt gemessene Spannung der Batteriezelle. Die ermittelte Zellspannung einer Batteriezelle zu dem Startzeitpunkt kann auch aus mehreren Messwerten berechnet werden, die zu mehreren Messzeitpunkten vor dem Startzeitpunkt aufgenommen wurden.

Zu dem Startzeitpunkt sowie zu den vor dem Startzeitpunkt liegenden Messzeitpunkten ist das Batteriemodul intakt. Insbesondere liegt keine Unterbrechung einer Messleitung vor, und alle Zellspannungen von allen Batteriezellen sind messbar. Die zu dem Startzeitpunkt ermittelten Werte der Zellspannungen der einzelnen Batteriezelle werden vorteilhaft gespeichert.

In einem Schritt b) erfolgt eine Ermittlung einer mittleren Zellenspannung aus den zu dem Startzeitpunkt ermittelten Zellspannungen der Batteriezellen zu dem Startzeitpunkt. Die mittlere Zellenspannung wird beispielsweise als arithmetischer Mittelwert aller ermittelten Werte der Zellspannungen der einzelnen Batteriezellen ermittelt. Auch die so ermittelte mittlere Zellenspannung wird vorteilhaft gespeichert.

In einem Schritt c) erfolgt ein Schätzen der Zellspannung von mindestens einer Batteriezelle zu einem Betriebszeitpunkt, wenn die Zellspannung der betreffenden Batteriezelle zu dem Betriebszeitpunkt nicht messbar ist. Der Schritt c) wird also ausgeführt, wenn ein Fehler in dem Batteriemodul aufgetreten ist, durch welchen die Zellspannung der betreffenden Batteriezelle nicht mehr messbar ist. Ein solcher Fehler tritt beispielsweise dann auf, wenn eine Messleitung zwischen der betreffenden Batteriezelle und einer Messschaltung unterbrochen ist.

Beim Schätzen der Zellspannung der betreffenden Batteriezelle werden dabei die zu dem Startzeitpunkt ermittelte Zellspannung der betreffenden Batteriezelle, die zu dem Startzeitpunkt ermittelte mittlere Zellenspannung und eine zu dem Betriebszeitpunkt ermittelte mittlere Zellenspannung berücksichtigt. Die zu dem Betriebszeitpunkt ermittelte mittlere Zellenspannung wird dabei aus den zu dem Betriebszeitpunkt gemessenen Zellspannungen der übrigen intakten Batteriezellen ermittelt.

Bei der Schätzung der Zellspannung der betreffenden Batteriezelle wird also insbesondere berücksichtigt, welche Zellspannung die Batteriezelle vor dem Eintritt des Fehlers hatte, als eine direkte Messung der Zellspannung noch möglich war. Auch wird berücksichtigt, wie die Zellspannungen der übrigen intakten Batteriezellen sich im laufenden Betrieb ändern. Dabei wird angenommen, dass die Zellspannung der betreffenden Batteriezelle sich auf ähnliche Weise ändert.

Gemäß der Erfindung werden nach dem Schritt b) und vor dem Schritt c), also insbesondere noch vor dem Eintritt eines Fehlers, durch welchen die Zellspannung von mindestens einer Batteriezelle nicht mehr messbar ist, noch die nachfolgend genannten Schritte ausgeführt:

Zunächst erfolgt eine Ermittlung eines oberen Schwellwerts "SO" als Summe aus der zu dem Startzeitpunkt ermittelten mittleren Zellenspannung "MS" und einem Toleranzwert "T". Der besagte Toleranzwert ist beispielsweise durch eine bekannte Messgenauigkeit der Messschaltung vorgegeben. Der obere Schwellwert errechnet sich folgendermaßen:

$$SO \quad = \quad MS \quad + \quad T$$

Ferner erfolgt eine Ermittlung eines unteren Schwellwerts "SU" als Differenz aus der zu dem Startzeitpunkt ermittelten mittleren Zellenspannung "MS" und einem Toleranzwert "T". Der besagte Toleranzwert ist beispielsweise durch eine bekannte Messgenauigkeit der Messschaltung vorgegeben und entspricht dem zuvor genannten Toleranzwert. Der untere Schwellwert errechnet sich folgendermaßen:

$$SU \quad = \quad MS \quad - \quad T$$

Anschließend erfolgt eine Klassifizierung von Batteriezellen, deren Zellspannung zu dem Startzeitpunkt höher als der obere Schwellwert ist, als gute Batteriezellen.

Ebenso erfolgt eine Klassifizierung von Batteriezellen, deren Zellspannung zu dem Startzeitpunkt geringer als der untere Schwellwert ist, als schlechte Batteriezellen.

Auch erfolgt eine Klassifizierung von Batteriezellen, deren Zellspannung zu dem Startzeitpunkt geringer als der obere Schwellwert oder gleich dem oberen Schwellwert und höher als der untere Schwellwert oder gleich dem unteren Schwellwert ist, als neutrale Batteriezellen.

Vor dem Ausführen des Schrittes c), also insbesondere vor dem Eintritt eines Fehlers, durch welchen die Zellspannung von mindestens einer Batteriezelle nicht mehr messbar ist, hat somit eine Klassifizierung der Batteriezellen des Batteriemoduls stattgefunden.

Gemäß der Erfindung wird bei Ausführung des Schrittes c) die Zellspannung von einer guten Batteriezelle zu dem Betriebszeitpunkt als Summe aus der zu dem Betriebszeitpunkt ermittelten mittleren Zellenspannung "MB" und einer Differenz aus der zu dem Startzeitpunkt ermittelte Zellspannung "US" der guten Batteriezelle und der zu dem Startzeitpunkt ermittelten mittleren Zellenspannung "MS" geschätzt. Die zu dem Betriebszeitpunkt geschätzte Zellspannung "UB" der guten Batteriezelle errechnet sich folgendermaßen:

$$UB \quad = \quad MB \quad + \quad US \quad - \quad MS$$

Die zu dem Startzeitpunkt ermittelte Zellspannung der guten Batteriezelle ist größer als die zu dem Startzeitpunkt ermittelte mittlere Zellenspannung. Somit ist die zu dem Betriebszeitpunkt geschätzte Zellspannung der guten Batteriezelle auch größer als die zu dem Betriebszeitpunkt ermittelte mittlere Zellenspannung. Vorzugsweise unterbleibt dabei eine Aufladung der guten Batteriezelle, wenn die zu dem Betriebszeitpunkt geschätzte Zellspannung der guten Batteriezelle größer ist als ein oberer Grenzwert. Der obere Grenzwert hängt dabei von einer maximal zulässigen Ladespannung ab, welche auch als "Charging Voltage Limit" (CVL) bezeichnet wird. Der obere Grenzwert beträgt beispielsweise 90% der maximal zulässigen Ladespannung. Auf diese Art wird eine Beschädigung durch Überladung der guten Batteriezelle, deren Zellspannung zu dem Betriebszeitpunkt nicht messbar ist, zuverlässig verhindert.

Auch kann eine Aufladung von allen Batteriezellen des Batteriemoduls unterbleiben, wenn die zu dem Betriebszeitpunkt geschätzte Zellspannung der guten Batteriezelle größer ist als der obere Grenzwert.

Gemäß der Erfindung wird bei Ausführung des Schrittes c) die Zellspannung von einer schlechten Batteriezelle zu dem Betriebszeitpunkt als Summe aus der zu dem Betriebszeitpunkt ermittelten mittleren Zellenspannung "MB" und einer Differenz aus der zu dem Startzeitpunkt ermittelten Zellspannung "US" der schlechten Batteriezelle und der zu dem Startzeitpunkt ermittelten mittleren Zellenspannung "MS" geschätzt. Die zu dem Betriebszeitpunkt geschätzte Zellspannung "UB" der guten Batteriezelle errechnet sich folgendermaßen:

$$UB \quad = \quad MB \quad + \quad US \quad - \quad MS$$

Die zu dem Startzeitpunkt ermittelte Zellspannung der schlechten Batteriezelle ist kleiner als die zu dem Startzeitpunkt ermittelte mittlere Zellenspannung. Somit ist die zu dem Betriebszeitpunkt geschätzte Zellspannung der schlechten Batteriezelle auch kleiner als die zu dem Betriebszeitpunkt ermittelte mittlere Zellenspannung.

Vorzugsweise unterbleibt dabei eine Entladung der schlechten Batteriezelle, wenn die zu dem Betriebszeitpunkt geschätzte Zellspannung der schlechten Batteriezelle kleiner ist als ein unterer Grenzwert. Der untere Grenzwert hängt dabei von einer minimal zulässigen Ladespannung ab, welche auch als "Discharging Voltage Limit" bezeichnet wird. Der untere Grenzwert beträgt beispielswiese 110% der minimal zulässigen Ladespannung. Auf diese Art wird eine Beschädigung durch Tiefentladung der schlechten Batteriezelle, deren Zellspannung zu dem Betriebszeitpunkt nicht messbar ist, zuverlässig verhindert. Auch kann eine Entladung von allen Batteriezellen des Batteriemoduls unterbleiben, wenn die zu dem Betriebszeitpunkt geschätzte Zellspannung der schlechten Batteriezelle kleiner ist als der untere Grenzwert.

Gemäß der Erfindung wird bei Ausführung des Schrittes c) die Zellspannung von einer neutralen Batteriezelle zu dem Betriebszeitpunkt als die zu dem Betriebszeitpunkt ermittelten mittleren Zellenspannung "MB" geschätzt. Die zu dem Betriebszeitpunkt geschätzte Zellspannung "UB" der neutralen Batteriezelle errechnet sich folgendermaßen:

$$UB \quad = \quad MB$$

Vorzugsweise unterbleibt dabei eine Aufladung der neutralen Batteriezelle, wenn die zu dem Betriebszeitpunkt geschätzte Zellspannung der neutralen Batteriezelle größer ist als ein oberer Grenzwert, und/oder wenn die zu dem Betriebszeitpunkt gemessene Zellspannung von mindestens einer guten Batteriezelle größer ist als der obere Grenzwert. Der obere Grenzwert hängt dabei von einer maximal zulässigen Ladespannung ab, welche auch als "Charging Voltage Limit" bezeichnet wird. Der obere Grenzwert beträgt beispielswiese 90% der maximal zulässigen Ladespannung. Auf diese Art wird eine Beschädigung durch Überladung der neutralen Batteriezelle, deren Zellspannung zu dem Betriebszeitpunkt nicht messbar ist, zuverlässig verhindert.

Auch kann eine Aufladung von allen Batteriezellen des Batteriemoduls unterbleiben, wenn die zu dem Betriebszeitpunkt geschätzte Zellspannung der neutralen Batteriezelle größer ist als der obere Grenzwert.

Vorzugsweise unterbleibt dabei eine Entladung der neutralen Batteriezelle, wenn die zu dem Betriebszeitpunkt geschätzte Zellspannung der neutralen Batteriezelle kleiner ist als ein unterer Grenzwert, und/oder wenn die zu dem Betriebszeitpunkt gemessene Zellspannung von mindestens einer schlechten Batteriezelle kleiner ist als der untere Grenzwert. Der untere Grenzwert hängt dabei von einer minimal zulässigen Ladespannung ab, welche auch als "Discharging Voltage Limit" (DVL) bezeichnet wird. Der untere Grenzwert beträgt beispielswiese 110% der minimal zulässigen Ladespannung. Auf diese Art wird eine Beschädigung durch Tiefentladung der neutralen Batteriezelle, deren Zellspannung zu dem Betriebszeitpunkt nicht messbar ist, zuverlässig verhindert.

Auch kann eine Entladung von allen Batteriezellen des Batteriemoduls unterbleiben, wenn die zu dem Betriebszeitpunkt geschätzte Zellspannung der neutralen Batteriezelle kleiner ist als der untere Grenzwert.

Das erfindungsgemäße Verfahren findet unter anderem vorteilhaft Verwendung in einem Batteriemodul eines reinen Elektrofahrzeugs, eines Hybridfahrzeugs, eines Plug-In-Hybridfahrzeugs oder eines e-Bikes. Aber auch andere Verwendungen sind denkbar.

Vorteile der Erfindung

Durch das erfindungsgemäße Verfahren ist eine maßgebliche Erhöhung der Sicherheit beim Betrieb eines Batteriemoduls sowie eines Elektrofahrzeugs erzielbar. Das erfindungsgemäße Verfahren erlaubt insbesondere, das Batteriemodul sowie das Elektrofahrzeug unter bestimmten Bedingungen weiter zu betreiben, auch wenn die Zellspannung einer Batteriezelle des Batteriemoduls nicht mehr messbar ist. Die besagte Erhöhung der Sicherheit wird insbesondere ohne zusätzlichen Hardwareaufwand erreicht. Es ist lediglich eine Anpassung von Software, beispielsweise in dem Batteriemanagementsystem, erforderlich.

Damit ist das erfindungsgemäße Verfahren vor allem kostengünstig realisierbar. Alle entscheidenden Messwerte liegen dem Batteriemanagementsystem bereits vor und müssen nur noch entsprechend verarbeitet werden. Bei der Klassifizierung der Batteriezellen ist eine beliebige Clusterung unterschiedlicher Batteriezellen applikativ als auch mit Methoden der künstlichen Intelligenz durchführbar. Sicherheitsstufen durch Sicherheitsschwellen beispielsweise obere Grenzwerte und untere Grenzwerte, sind individuell anpassbar. Durch das erfindungsgemäße Verfahren kann beispielsweise sichergestellt werden, dass ein Shuttle weiterhin pünktlich eine nächste Haltestelle erreicht, sowie, dass eine Weiterfahrt bis zu einer Endhaltestelle oder zu einer Servicestation möglich ist, wo eine Reparatur erfolgen kann. Auch ist eine höhere Reichweite erzielbar. Das Verfahren ist von der Batteriegröße und dem Batteriemodulaufbau, insbesondere von der Art der Verschaltung der Batteriezellen, serielle oder parallel, unabhängig.

Kurze Beschreibung der Zeichnungen

Ausführungsformen der Erfindung werden anhand der Zeichnungen und der nachfolgenden Beschreibung näher erläutert.

Es zeigen:

Figur 1    eine schematische Darstellung eines Batteriemoduls mit mehreren Batteriezellen,

Figur 2:    ein Diagramm zur Darstellung von Zellspannungen der Batteriezellen des Batteriemoduls zu einem Startzeitpunkt und

Figur 3:    eine schematische Darstellung eines Verfahrens zum Betreiben eines Batteriemoduls.

Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

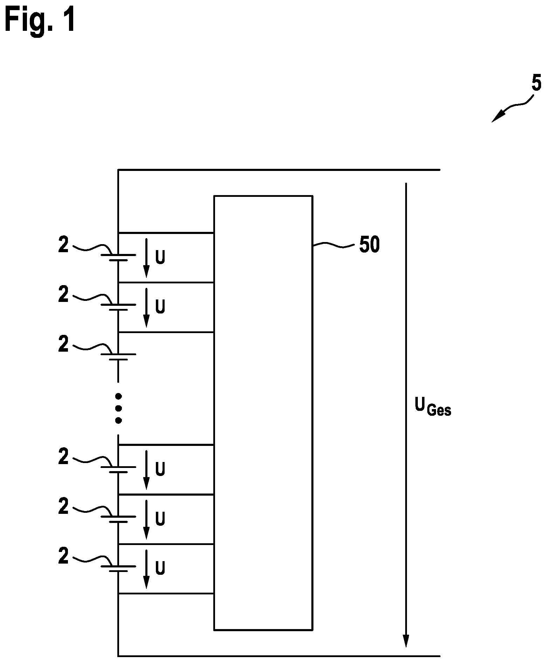

Figur 1 zeigt eine schematische Darstellung eines Batteriemoduls 5 mit mehreren Batteriezellen 2. Die Batteriezellen 2 sind vorliegend elektrisch seriell verschaltet. Jede Batteriezelle 2 umfasst eine Elektrodeneinheit, welche jeweils eine Anode und eine Kathode aufweist. Die Anode der Elektrodeneinheit ist mit einem negativen Terminal der Batteriezelle 2 verbunden. Die Kathode der Elektrodeneinheit ist mit einem positiven Terminal der Batteriezelle 2 verbunden. Zur seriellen Verschaltung der Batteriezellen 2 des Batteriemoduls 5 ist jeweils das negative Terminal einer Batteriezelle 2 mit dem positiven Terminal der benachbarten Batteriezelle 2 elektrisch verbunden.

Das Batteriemodul 5 umfasst auch eine Messschaltung 50. Die Messschaltung 50 dient zur Messung von Zellspannungen U der Batteriezellen 2 des Batteriemoduls 5 und zur Messung einer Gesamtspannung UGes des Batteriemoduls 5. Die Gesamtspannung UGes des Batteriemoduls 5 entspricht vorliegend der Summe aus den Zellspannungen U der einzelnen Batteriezellen 2. Die Batteriezellen 2 sind mittels Messleitungen mit der Messschaltung 50 verbunden.

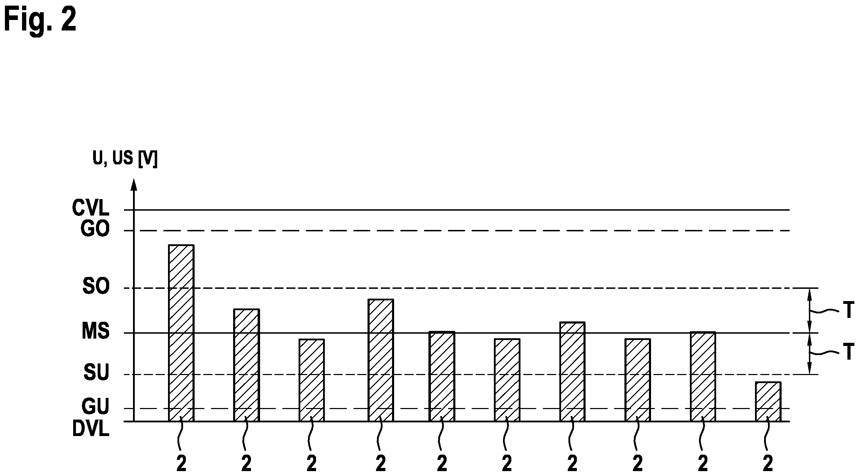

Figur 2 zeigt ein Diagramm zur Darstellung von Zellspannungen US der Batteriezellen 2 des in Figur 1 dargestellten Batteriemoduls 5 zu einem Startzeitpunkt. Zu dem Startzeitpunkt ist das Batteriemodul 5 intakt, insbesondere ist keine der Messleitungen unterbrochen, und alle Zellspannungen US aller Batteriezellen 2 zu dem Startzeitpunkt sind messbar.

Aus allen zu dem Startzeitpunkt ermittelten Zellspannungen US aller Batteriezellen 2 des Batteriemoduls 5 wird eine mittlere Zellenspannung MS zu dem Startzeitpunkt ermittelt. Die mittlere Zellenspannung MS zu dem Startzeitpunkt wird vorliegend als arithmetischer Mittelwert aller ermittelten Werte der Zellspannungen US zu dem Startzeitpunkt der einzelnen Batteriezellen 2 ermittelt.

Anschließend wird ein oberer Schwellwert SO als Summe aus der ermittelten mittleren Zellenspannung MS zu dem Startzeitpunkt und einem Toleranzwert T ermittelt. Ebenso wird ein unterer Schwellwert SU als Differenz aus der ermittelten mittleren Zellenspannung MS zu dem Startzeitpunkt und einem Toleranzwert T ermittelt. Im vorliegenden Beispiel sind die Toleranzwerte T, welche zur Ermittlung des oberen Schwellwerts SO und des unteren Schwellwerts SU benutzt werden, gleich. Der besagte Toleranzwert T ist beispielsweise durch eine bekannte Messgenauigkeit der Messschaltung 50 vorgegeben.

Danach erfolgt eine Klassifizierung von Batteriezellen 2, deren Zellspannung US zu dem Startzeitpunkt höher als der obere Schwellwert SO ist, als gute Batteriezellen 2. Ebenso erfolgt eine Klassifizierung von Batteriezellen 2, deren Zellspannung US zu dem Startzeitpunkt geringer als der untere Schwellwert SU ist, als schlechte Batteriezellen 2. Auch erfolgt eine Klassifizierung von Batteriezellen 2, deren Zellspannung US zu dem Startzeitpunkt geringer als der obere Schwellwert SO oder gleich dem oberen Schwellwert SO und höher als der untere Schwellwert SU oder gleich dem unteren Schwellwert SU ist, als neutrale Batteriezellen 2. Wie aus dem Diagramm ersichtlich ist, werden vorliegend acht Batteriezellen 2 als neutrale Batteriezellen 2 klassifiziert, eine Batteriezelle 2 wird als gute Batteriezelle 2 klassifiziert, und eine Batteriezelle 2 wird als schlechte Batteriezelle 2 klassifiziert.

Eine Aufladung einer Batteriezelle 2 unterbleibt, wenn deren gemessene Zellspannung UB zu einem Betriebszeitpunkt größer ist als eine maximal zulässige Ladespannung CVL. Eine Aufladung einer Batteriezelle 2 unterbleibt, wenn deren geschätzte Zellspannung UB zu einem Betriebszeitpunkt größer ist als ein oberer Grenzwert GO. Der obere Grenzwert GO beträgt beispielswiese 90% der maximal zulässigen Ladespannung CVL. Auf diese Art wird eine Beschädigung durch Überladung der Batteriezelle 2 zuverlässig verhindert.

Eine Entladung einer Batteriezelle 2 unterbleibt, wenn deren gemessene Zellspannung UB zu einem Betriebszeitpunkt kleiner ist als eine minimal zulässige Ladespannung DVL. Eine Entladung einer Batteriezelle 2 unterbleibt, wenn deren geschätzte Zellspannung UB zu einem Betriebszeitpunkt kleiner ist als ein unterer Grenzwert GU. Der untere Grenzwert GU beträgt beispielswiese 110% der minimal zulässigen Ladespannung DVL. Auf diese Art wird eine Beschädigung durch Tiefentladung der Batteriezelle 2 zuverlässig verhindert.

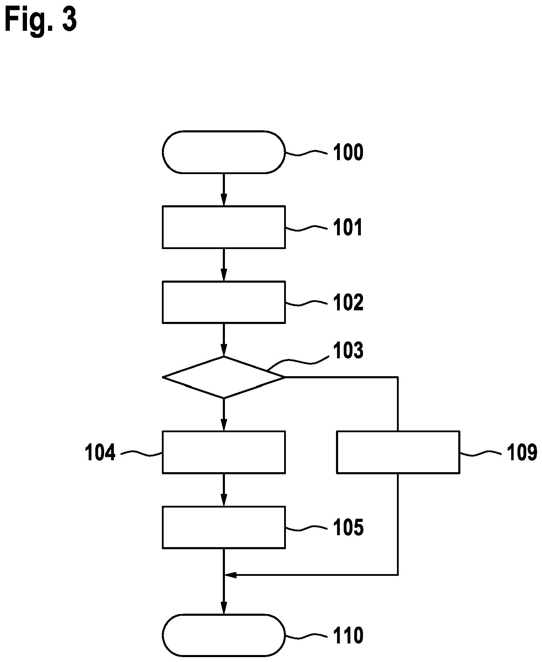

Figur 3 zeigt eine schematische Darstellung eines Verfahrens zum Betreiben eines Batteriemoduls 5.

In einem Startschritt 100 werden zu einem Startzeitpunkt die Zellspannungen US der Batteriezellen 2 des Batteriemoduls 5 ermittelt. Aus den zu dem Startzeitpunkt ermittelten Zellspannungen US der Batteriezellen 2 wird die mittlere Zellenspannung MS zu dem Startzeitpunkt ermittelt. Ebenso wird der obere Schwellwert SO als Summe aus der mittleren Zellenspannung MS zu dem Startzeitpunkt und dem Toleranzwert T ermittelt. Auch wird der untere Schwellwert SU als Differenz aus der mittleren Zellenspannung MS zu dem Startzeitpunkt und dem Toleranzwert T ermittelt.

In einem folgenden Schritt 101 erfolgt die Klassifizierung derjenigen Batteriezellen 2, deren Zellspannung US zu dem Startzeitpunkt höher als der obere Schwellwert SO ist, als gute Batteriezellen 2. Auch erfolgt die Klassifizierung derjenigen Batteriezellen 2, deren Zellspannung US zu dem Startzeitpunkt geringer als der untere Schwellwert SU ist, als schlechte Batteriezellen 2. Ebenso erfolgt die Klassifizierung derjenigen Batteriezellen 2, deren Zellspannung US zu dem Startzeitpunkt geringer als der obere Schwellwert SO oder gleich dem oberen Schwellwert SO und höher als der untere Schwellwert SU oder gleich dem unteren Schwellwert SU ist, als neutrale Batteriezellen 2.

In einem nächsten Schritt 102 tritt zu einem Betriebszeitpunkt ein Fehler auf. Beispielsweise wird eine Messleitung des Batteriemoduls 5 unterbrochen. Aufgrund dieses Fehlers ist mindestens eine Zellspannung UB von mindestens einer Batteriezelle 2 zu dem Betriebszeitpunkt nicht mehr messbar. In dem in Figur 1 dargestellten Batteriemodul 5 kann eine Unterbrechung einer Messleitung auch verursachen, dass die Zellspannungen UB von zwei benachbarten Batteriezellen 2 zu dem Betriebszeitpunkt nicht mehr messbar sind.

In einem folgenden Schritt 103 bestimmt das Batteriemanagementsystem anhand aller verfügbaren Messwerte, welche Art von Fehler vorliegt.

Wenn beispielsweise ein Kurzschluss in einer der Batteriezellen 2 vorliegt, so fließt in der betreffenden Batteriezelle 2 ein Kurzschlussstrom, welcher eine starke Temperaturerhöhung der Batteriezelle 2 verursacht. Das Batteriemanagementsystem registriert die Temperaturerhöhung, schließt in dem Schritt 103 auf einen Kurzschluss in der Batteriezelle 2 und schaltet daraufhin in einem Schritt 109 das Batteriemodul 5 ab.

Wenn beispielsweise eine Leiterunterbrechung in dem Batteriemodul 5 zwischen den Batteriezellen 2 vorliegt, so ist keine Gesamtspannung UGes mehr messbar, beziehungsweise das Batteriemanagementsystem misst vermeintlich eine Gesamtspannung UGes des Batteriemoduls 5 von etwa null Volt. Das Batteriemanagementsystem schließt in dem Schritt 103 auf eine Leiterunterbrechung in dem Batteriemodul 5 und schaltet daraufhin in einem Schritt 109 das Batteriemodul 5 ab.

Nach dem Abschalten des Batteriemoduls 5 in dem Schritt 109 enden dann der Betrieb des Batteriemoduls 5 und der Fahrbetrieb des Fahrzeugs mit einem Endschritt 110.

Sofern keine auf einen Kurzschluss hinweisende Temperaturerhöhung gemessen wird, und sofern die Gesamtspannung UGes des Batteriemoduls 5 weiterhin messbar ist und plausible Messwerte liefert, so schließt das Batteriemanagementsystem in dem Schritt 103 auf eine Unterbrechung einer Messleitung zwischen den Batteriezellen 2 und der Messschaltung 50.

In diesem Fall werden in einem folgenden Schritt 104 zu einem Betriebszeitpunkt die Zellspannungen UB der betreffenden Batteriezellen 2, deren Zellspannungen UB zu dem Betriebszeitpunkt aufgrund der Unterbrechung der Messleitung nicht mehr messbar sind, geschätzt.

In einem nachfolgenden Schritt 105 erfolgt ein weiterer Betrieb des Batteriemoduls 5 ebenso wie ein weiterer Fahrbetrieb des Fahrzeugs.

Der Betrieb des Batteriemoduls 5 und der Fahrbetrieb des Fahrzeugs enden zu einem späteren Zeitpunkt mit dem Endschritt 110.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

**Patentansprüche**

1. Verfahren zum Betrieb eines Batteriemoduls (5), mit mehreren Batteriezellen (2), umfassend folgende Schritte:

   a) Ermittlung der Zellspannungen (US) der einzelnen Batteriezellen (2) zu einem Startzeitpunkt;
   b) Ermittlung einer mittleren Zellenspannung (MS) aus den zu dem Startzeitpunkt ermittelten Zellspannungen (US) der Batteriezellen (2) zu dem Startzeitpunkt;
   c) Schätzen der Zellspannung (UB) von mindestens einer Batteriezelle (2) zu einem Betriebszeitpunkt, wenn die Zellspannung (UB) der Batteriezelle (2) zu dem Betriebszeitpunkt nicht messbar ist, wobei

   beim Schätzen der Zellspannung (UB) der Batteriezelle (2) zu dem Betriebszeitpunkt die zu dem Startzeitpunkt ermittelte Zellspannung (US) der Batteriezelle (2),
   die zu dem Startzeitpunkt ermittelte mittlere Zellenspannung (MS) und
   eine zu dem Betriebszeitpunkt ermittelte mittlere Zellenspannung (MB) berücksichtigt werden, wobei
   die zu dem Betriebszeitpunkt ermittelte mittlere Zellenspannung (MB) aus den zu dem Betriebszeitpunkt gemessenen Zellspannungen (UB) der übrigen Batteriezellen (2) ermittelt wird
   wobei nach Schritt b) folgende Schritte ausgeführt werden:

   - Ermittlung eines oberen Schwellwerts (SO) als Summe aus der zu dem Startzeitpunkt ermittelten mittleren Zellenspannung (MS) und einem Toleranzwert (T);
   - Ermittlung eines unteren Schwellwerts (SU) als Differenz aus der zu dem Startzeitpunkt ermittelten mittleren Zellenspannung (MS) und dem Toleranzwert (T);
   - Klassifizierung von Batteriezellen (2), deren Zellspannung (US) zum Startzeitpunkt höher als der obere Schwellwert (SO) ist, als gute Batteriezellen (2);
   - Klassifizierung von Batteriezellen (2), deren Zellspannung (US) zum Startzeitpunkt geringer als der untere Schwellwert (SU) ist, als schlechte Batteriezellen (2);
   - Klassifizierung von Batteriezellen (2), deren Zellspannung (US) zum Startzeitpunkt geringer als der obere Schwellwert (SO) und höher als der untere Schwellwert (SU) ist, als neutrale Batteriezellen (2),

   wobei die Zellspannung (UB) von einer guten Batteriezelle (2) zu dem Betriebszeitpunkt als Summe aus der zu dem Betriebszeitpunkt ermittelten mittleren Zellenspannung (MB) und einer Differenz aus der zu dem Startzeitpunkt ermittelten Zellspannung (US) der guten Batteriezelle (2) und der zu dem Startzeitpunkt ermittelten mittleren Zellenspannung (MS) geschätzt wird,
   wobei die Zellspannung (UB) von einer schlechten Batteriezelle (2) zu dem Betriebszeitpunkt als Summe aus der zu dem Betriebszeitpunkt ermittelten mittleren Zellenspannung (MB) und einer Differenz aus der zu dem Startzeitpunkt ermittelten Zellspannung (US) der schlechten Batteriezelle (2) und der zu dem Startzeitpunkt ermittelten mittleren Zellenspannung (MS) geschätzt wird,
   wobei die Zellspannung (UB) von einer neutralen Batteriezelle (2) zu dem Betriebszeitpunkt als die zu dem Betriebszeitpunkt ermittelte mittlere Zellenspannung (MB) geschätzt wird.

2. Verfahren nach Anspruch 1, wobei
   eine Aufladung der guten Batteriezelle (2) und/ oder des Batteriemoduls (5) unterbleibt, wenn die zu dem Betriebszeitpunkt geschätzte Zellspannung (UB) der guten Batteriezelle (2) größer ist als ein oberer Grenzwert (GO).

3. Verfahren nach einem der Ansprüche 1 oder 2, wobei
   eine Entladung der schlechten Batteriezelle (2) und/ oder des Batteriemoduls (5) unterbleibt, wenn die zu dem Betriebszeitpunkt geschätzte Zellspannung (UB) der schlechten Batteriezelle (2) kleiner ist als ein unterer Grenzwert (GU).

**4.** Verfahren nach einem der Ansprüche 1 bis 3, wobei

eine Aufladung der neutralen Batteriezelle (2) und/ oder des Batteriemoduls (5) unterbleibt,
wenn die zu dem Betriebszeitpunkt geschätzte Zellspannung (UB) der neutralen Batteriezelle (2) größer ist als
der obere Grenzwert (GO), und/oder wenn die zu dem Betriebszeitpunkt gemessene Zellspannung (UB) von
mindestens einer guten Batteriezelle (2) größer ist als der obere Grenzwert (GO).

**5.** Verfahren nach einem der Ansprüche 1 bis 4, wobei

eine Entladung der neutralen Batteriezelle (2) und/ oder des Batteriemoduls (5) unterbleibt,
wenn die zu dem Betriebszeitpunkt geschätzte Zellspannung (UB) der neutralen Batteriezelle (2) kleiner ist als
der untere Grenzwert (GU), und/oder wenn die zu dem Betriebszeitpunkt gemessene Zellspannung (UB) von
mindestens einer schlechten Batteriezelle (2) kleiner ist als der untere Grenzwert (GU).

**6.** Verwendung des Verfahrens nach einem der vorstehenden Ansprüche in einem Batteriemodul (5) eines reinen
Elektrofahrzeugs, eines Hybridfahrzeugs, eines Plug-In-Hybridfahrzeugs oder eines e-Bikes.


**Claims**

**1.** Method for operating a battery module (5), having multiple battery cells (2), comprising the following steps:

a) determining the cell voltages (US) of the individual battery cells (2) at a start time;
b) determining an average cell voltage (MS) at the start time from the cell voltages (US) of the battery cells (2)
determined at the start time;
c) estimating the cell voltage (UB) of at least one battery cell (2) at an operating time when the cell voltage (UB)
of the battery cell (2) is not able to be measured at the operating time, wherein

the estimation of the cell voltage (UB) of the battery cell (2) at the operating time takes into account the cell
voltage (US) of the battery cell (2) determined at the start time,
the average cell voltage (MS) determined at the start time and
an average cell voltage (MB) determined at the operating time, wherein
the average cell voltage (MB) determined at the operating time is determined from the cell voltages (UB)
of the other battery cells (2) measured at the operating time,
wherein
after step b) the following steps are carried out:

- determining an upper threshold value (SO) as the sum of the average cell voltage (MS) determined
at the start time and a tolerance value (T);
- determining a lower threshold value (SU) as the difference between the average cell voltage (MS)
determined at the start time and the tolerance value (T) ;
- classifying battery cells (2) whose cell voltage (US) at the start time is higher than the upper threshold
value (SO) as good battery cells (2);
- classifying battery cells (2) whose cell voltage (US) at the start time is lower than the lower threshold
value (SU) as bad battery cells (2);
- classifying battery cells (2) whose cell voltage (US) at the start time is lower than the upper threshold
value (SO) and higher than the lower threshold value (SU) as neutral battery cells (2),

wherein the cell voltage (UB) of a good battery cell (2) at the operating time is estimated as the sum of the
average cell voltage (MB) determined at the operating time and a difference between the cell voltage (US)
of the good battery cell (2) determined at the start time and the average cell voltage (MS) determined at
the start time,
wherein the cell voltage (UB) of a bad battery cell (2) at the operating time is estimated as the sum of the
average cell voltage (MB) determined at the operating time and a difference between the cell voltage (US)
of the bad battery cell (2) determined at the start time and the average cell voltage (MS) determined at the
start time,
wherein the cell voltage (UB) of a neutral battery cell (2) at the operating time is estimated as the average
cell voltage (MB) determined at the operating time.

**2.** Method according to Claim 1, wherein
charging of the good battery cell (2) and/or the battery module (5) is stopped when the cell voltage (UB) of the good battery cell (2) estimated at the operating time is greater than an upper limit value (GO) .

**3.** Method according to Claim 1 or 2, wherein discharging of the bad battery cell (2) and/or the battery module (5) is stopped when the cell voltage (UB) of the bad battery cell (2) estimated at the operating time is lower than a lower limit value (GU).

**4.** Method according to one of Claims 1 to 3, wherein charging of the neutral battery cell (2) and/or the battery module (5) is stopped

when the cell voltage (UB) of the neutral battery cell (2) estimated at the operating time is greater than the upper limit value (GO), and/or
when the cell voltage (UB) of at least one good battery cell (2) measured at the operating time is greater than the upper limit value (GO).

**5.** Method according to one of Claims 1 to 4, wherein discharging of the neutral battery cell (2) and/or the battery module (5) is stopped

when the cell voltage (UB) of the neutral battery cell (2) estimated at the operating time is lower than the lower limit value (GU), and/or
when the cell voltage (UB) of at least one bad battery cell (2) measured at the operating time is lower than the lower limit value (GU).

**6.** Use of the method according to one of the preceding claims in a battery module (5) of a pure electric vehicle, a hybrid vehicle, a plug-in hybrid vehicle or an e-bike.


**Revendications**

**1.** Procédé pour faire fonctionner un module de batterie (5) comportant plusieurs cellules de batterie (2), comprenant les étapes suivantes :

a) détermination des tensions de cellule (US) des cellules de batterie (2) individuelles à un instant de départ ;
b) détermination d'une tension de cellule moyenne (MS) des cellules de batterie (2) à l'instant de départ à partir des tensions de cellule (US) déterminées à l'instant de départ ;
c) estimation de la tension de cellule (UB) d'au moins une cellule de batterie (2) à un instant de fonctionnement lorsque la tension de cellule (UB) de la cellule de batterie (2) à l'instant de fonctionnement n'est pas mesurable, dans lequel

lors de l'estimation de la tension de cellule (UB) la tension de cellule (US) de la cellule de batterie (2) à l'instant de départ, la tension de cellule (US) déterminée à l'instant de départ de la cellule de batterie (2), la tension de cellule moyenne (MS) déterminée à l'instant de départ et une tension de cellule moyenne (MB) déterminée à l'instant de fonctionnement sont prises en compte, dans lequel
la tension de cellule moyenne (MB) déterminée à l'instant de fonctionnement est déterminée à partir des tensions de cellule (UB), mesurées à l'instant de fonctionnement, des cellules de batterie (2) restantes, dans lequel les étapes suivantes sont exécutées après l'étape b) :

- détermination d'une valeur de seuil supérieure (SO) comme étant la somme de la tension de cellule moyenne (MS) déterminée à l'instant de départ et d'une valeur de tolérance (T) ;
- détermination d'une valeur de seuil inférieure (SU) comme étant la différence entre la tension de cellule moyenne (MS) déterminée à l'instant de départ et la valeur de tolérance (T) ;
- classement comme étant des cellules de batterie (2) de bonne qualité, des cellules de batterie (2) dont la tension de cellule (US) est supérieure à la valeur de seuil supérieure (SO) à l'instant de départ ;
- classement comme étant des cellules de batterie (2) de mauvaise qualité, des cellules de batterie (2) dont la tension de cellule (US) est inférieure à la valeur de seuil inférieure (SU) à l'instant de départ ;
- classement comme étant des cellules de batterie (2) neutres, des cellules de batterie (2) dont la tension de cellule (US) est inférieure à la valeur de seuil supérieure (SO) et supérieure à la valeur de seuil inférieure (SU) à l'instant de départ,

dans lequel la tension de cellule (UB) d'une cellule de batterie (2) de bonne qualité à l'instant de fonctionnement est estimée comme étant la somme de la tension de cellule moyenne (MB) déterminée à l'instant de fonctionnement et d'une différence entre la tension de cellule (US) déterminée à l'instant de départ de la cellule de batterie (2) de bonne qualité et la tension de cellule moyenne (MS) déterminée à l'instant de départ, dans lequel la tension de cellule (UB) d'une cellule de batterie (2) de mauvaise qualité à l'instant de fonctionnement est estimée comme étant la somme de la tension de cellule moyenne (MB) déterminée à l'instant de fonctionnement et d'une différence entre la tension de cellule (US) de la cellule de batterie (2) de mauvaise qualité déterminée à l'instant de départ et la tension de cellule moyenne (MS) déterminée à l'instant de départ, dans lequel la tension de cellule (UB) d'une cellule de batterie (2) neutre à l'instant de fonctionnement est estimée comme étant la tension de cellule moyenne (MB) déterminée à l'instant de fonctionnement.

2. Procédé selon la revendication 1, dans lequel il ne se produit pas de charge de la cellule de batterie (2) de bonne qualité et/ou du module de batterie (5) lorsque la tension de cellule (UB) de la cellule de batterie (2) de bonne qualité, estimée à l'instant de fonctionnement, est supérieure à une valeur limite supérieure (GO).

3. Procédé selon l'une des revendications 1 ou 2, dans lequel
il ne se produit pas de décharge de la cellule de batterie (2) de mauvaise qualité et/ou du module de batterie (5) lorsque la tension de cellule (UB) de la cellule de batterie (2) de mauvaise qualité, estimée à l'instant de fonctionnement, est inférieure à une valeur limite inférieure (GU).

4. Procédé selon l'une des revendications 1 à 3, dans lequel

il ne se produit pas de charge de la cellule de batterie (2) neutre et/ou du module de batterie (5)
lorsque la tension de cellule (UB) de la cellule de batterie (2) neutre, estimée à l'instant de fonctionnement, est supérieure à la valeur limite supérieure (GO), et/ou
lorsque la tension de cellule (UB) d'au moins une cellule de batterie (2) de bonne qualité, mesurée à l'instant de fonctionnement, est supérieure à la valeur limite supérieure (GO).

5. Procédé selon l'une des revendications 1 à 4, dans lequel

il ne se produit pas de décharge de la cellule de batterie (2) neutre et/ou du module de batterie (5)
lorsque la tension de cellule (UB) de la cellule de batterie (2) neutre, estimée à l'instant de fonctionnement, est inférieure à la valeur limite inférieure (GU), et/ou
lorsque la tension de cellule (UB) d'au moins une cellule de batterie (2) de mauvaise qualité, mesurée à l'instant de fonctionnement, est inférieure à la valeur limite inférieure (GU).

6. Utilisation du procédé selon l'une des revendications précédentes dans un module de batterie (5) d'un véhicule purement électrique, d'un véhicule hybride, d'un véhicule hybride rechargeable ou d'un vélo électrique.

# Fig. 1

Fig. 2

# Fig. 3

**IN DER BESCHREIBUNG AUFGEFÜHRTE DOKUMENTE**

**In der Beschreibung aufgeführte Patentdokumente**

- DE 102017116573 A1
- DE 102014207395 A1
- US 2005225290 A1
- DE 102013205334 A1
- US 2006273802 A1
- WO 2015037292 A1